Europäisches Patentamt

European Patent Office

Office européen des brevets

(11) Publication number : **0 590 938 A2**

# (12) EUROPEAN PATENT APPLICATION

(21) Application number : 93307681.2

(22) Date of filing : 28.09.93

(51) Int. Cl.⁵ : **H03C 3/00**

(30) Priority : **28.09.92 JP 257702/92**
**27.01.93 JP 11619/93**

(43) Date of publication of application :
**06.04.94 Bulletin 94/14**

(84) Designated Contracting States :
**DE GB**

(71) Applicant : **KABUSHIKI KAISHA TOSHIBA**
**72, Horikawa-cho,Saiwai-ku, Kawasaki-shi**
**Kanagawa-ken 210 (JP)**

(71) Applicant : **TOSHIBA AUDIO VIDEO**
**ENGINEERING CO., LTD.**
**3-3-9, Shinbashi Minato-ku**
**Tokyo (JP)**

(72) Inventor : Ikeda, Kazumasa, c/o Intellectual
Property Div.
Toshiba Corporation, 1-1-1, Shibaura,
Minato-ku
Tokyo (JP)
Inventor : Sumiyoshi, Masatoshi, c/o Intel.
Property Division
Toshiba Corporation, 1-1-1, Shibauara,
Minato-ku
Tokyo (JP)

(74) Representative : **Muir, Ian R. et al**
**HASELTINE LAKE & CO. Hazlitt House 28**
**Southampton Buildings Chancery Lane**
**London WC2A 1AT (GB)**

(54) **Digital frequency modulator.**

(57) A digital modulator includes an integrator and a phase modulator. In the integrator, an input signal is supplied to an adder (112) and is added to output data of a register (116) positioned at a later stage in the integrator. Added data provided from the adder (112) is compared with a predetermined value and is supplied to a first subtracter (113) and a first selector (115). The first subtracter (113) subtracts the predetermined value from the added data and supplies difference data to the first selector (115). The first selector (115) selects the added data to supply it to the register (116) when the added data is less than the predetermined value, and selects the difference data when the added data is not less than the predetermined value. The register (116) outputs the added data or the difference data at the timing of a clock signal. In the phase modulator, the output data of the register is supplied to a second subtracter (212) and is subtracted from a reference value equal to half the value of the above predetermined value. The second subtracter (212) provides the difference data and supplies borrow data to a second selector (217). An absolute-value of the difference data is supplied to a memory (214) as read address data, and the memory (214) provides half-cycle data of a sine function. In accordance with the borrow data, the second selector (217) selectively outputs one of the half-cycle data and the inverted half-cycle data generated by a negative or inverting amplifier (216).

EP 0 590 938 A2

The present invention generally relates to the frequency modulation field, and more particularly, is directed to a digital frequency modulator which employs an integrator for converting an input signal to phase data and a phase modulator for converting the phase data to frequency data. The phase modulator typically employs a memory for storing the frequency data.

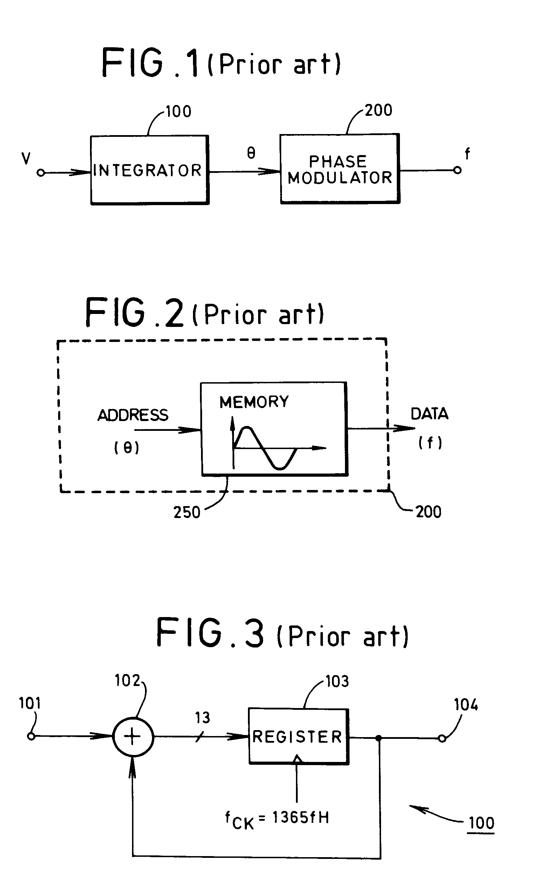

Figure 1 is a block diagram illustrating a previously known digital frequency modulator. This frequency modulator employs integrator 100 for integrating an input signal having a certain voltage level (V) and for outputting integrated data as phase data ($\theta$). The frequency modulator also employs phase modulator 200 for converting the phase data ($\theta$) to frequency data (f) indicating different frequencies according to the phase data. As a result, the input signal is modulated to the frequency data.

Figure 2 is a block diagram illustrating a known example of the phase modulator 200 used for the digital frequency modulator shown in Figure 1. ROM (read only memory) - type memory 250 is employed for storing sine wave data. Memory 250 is supplied with read address data which indicates phase $\theta$ in the range $\{0 \leqq \theta \leqq 2\pi\}$ where $\pi$ is the ratio of the circumference at a circle to its diameter. Therefore, the data of the $\sin\theta$ function $f(\theta) = \sin\theta$ stored in memory 250 are read out as frequency data (f) according to the read address data ($\theta$).

Figure 3 is a block diagram illustrating a conventional integrator 100 used for the frequency modulator of Figure 1. In this integrator, an input signal supplied to input terminal 101 is added to output data from register 103 by adder 102. Adder 102 supplies added output data to register 103 which is driven by a clock signal having a frequency $f_{ck}$, and register 103 supplies them to output terminal 104 and adder 102 according to the timing of the clock signal, so that the input signal is integrated.

In this process, when the input signal has a constant voltage, like level "1" of a digital signal, this integrator functions as a counter circuit which is driven by a clock signal having a frequency $f_{ck}$. In this case, the counter regression value L1 of the integrator depends on a bit-width of the signal lines which transmit the input signal, the added data and so forth. The counter regression value will be explained in greater detail herein, but, briefly in the case where a bit-width of the signal lines is N bits, the counter regression value L1 is the Nth power of 2. Thus, the integrated data is automatically preset to "0" at the same time as the integrated data becomes equal to the counter regression value L1.

In the digital frequency modulator of Figure 3, the frequency resolution $\Delta f$ is expressed by the following formula:

$$\Delta f = f_{ck}/L1 \quad (1)$$

In addition, in the case of a frequency modulator used for a VCR (video cassette recorder), a carrier shift is taken into account. Namely, in the EP (extended play) mode, the triple speed mode of the VHS system for instance, a carrier signal is shifted by $f_H/2$ (half of the horizontal synchronizing frequency $f_H$ of the video signal) in order to eliminate a cross-talk beat of the horizontal synchronizing signal between the two adjacent tracks on the video tape by a filter. For this reason, it is necessary to make an integral multiple of the frequency resolution $\Delta f$ equal to $f_H/2$. In other words, a relation expressed by the following formula:

$$f_H/2 = n \cdot \Delta f \quad (2)$$

where n is an integer, must be established. According to formula (1), formula (2) is expressed as the following:

$$f_H/2 = n \cdot f_{ck}/L1 \quad (3)$$

Taking into account the carrier shift, in the conventional integrator for a VCR, the counter regression value L1 is selected at "8192" which is the 13th power of 2, and the clock frequency $f_{ck}$ is selected at $1365f_H$. However, in this case, when applying these values to formula (3), "n" does not completely become an integer, namely, n=3.0007326---.

For this reason, there are errors because $f_H/2$ is not exactly an integral multiple of the frequency resolution $\Delta f$. Therefore, elimination of the cross-talk beat cannot be completely achieved. This is due to the fact that the counter regression value L1 must be set to the Nth power of 2. If the value L1 could be set as a free value without it being the Nth power of 2, "n" would become an integer.

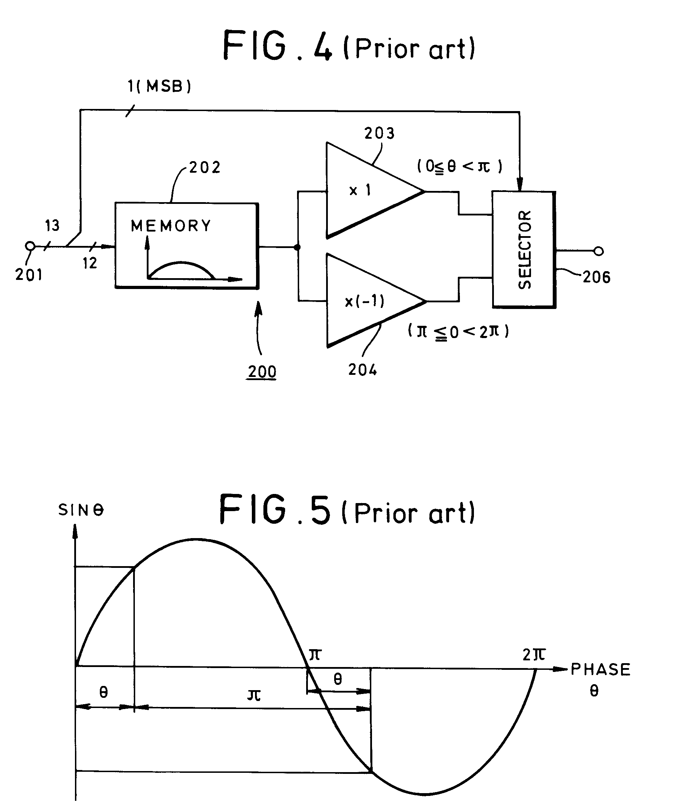

On the other hand, Figure 4 is a block diagram illustrating a conventional digital phase modulator used practically for phase modulator 200 shown in Figure 1. In this circuitry, phase data $\theta$ corresponding to output data of the integrator of Figure 3 is supplied to input terminal 201, and is divided into the MSB (most significant bit) and the remaining lower bits. The MSB is supplied to the control terminal of selector 205, while the remaining lower bits, which are 12 bits in this case, are supplied as the read address data to memory 202 storing the data of the sine function. The output data from memory 202 is supplied to both positive $\{x1\}$ amplifier 203 and negative $\{x(-1)\}$ or inverting amplifier 204. The output signals of these amplifiers are supplied to the respective input terminals of selector 205. Selector 205 selects one of these input terminals of selector 205 in accordance with the polarity of the MSB at the control terminal, and supplies the signal from the selected input terminal to output terminal 206.

In the phase modulator of Figure 4, memory 202 may store only half-cycle data of the sine wave corresponding to phase $\theta$ in the range $\{0 \leqq \theta < \pi\}$ since this circuitry uses the characteristic of the sine function $\sin\theta = -\sin(\theta+\pi)$. This characteristic is apparent from Figure 5 which is a wave form chart showing the sine function. The remaining half-cycle data corresponding to phase $\theta$ in the range $\{\pi \leqq \theta < 2\pi\}$ is pro-

duced by inverting the output data of memory 202.

Since the conventional phase modulator is designed so that the number of read address data corresponding to phase $\theta$ in the full-cycle range $\{0 \leqq \theta < 2\pi\}$ is the Nth power of 2, the read address data corresponding to phase $\theta$ in the half-cycle range $\{0 \leqq \theta < \pi\}$ is expressed by N-1 bits except the MSB. In this example, N is set equal to 13. Therefore, the 12 bit read address data, the remaining data, is supplied to memory 202. In addition, the MSB indicates whether the phase $\theta$ of the original 13 bit read address data is included in the range $\{0 \leqq \theta < \pi\}$ or the range $\{\pi \leqq \theta < 2\pi\}$. Thus, when the value of the MSB is "0", since the phase $\theta$ is included in the range $\{0 \leqq \theta < \pi\}$, selector 205 selects the input signal supplied by positive amplifier 203. Oppositely, when the value of the MSB is "1", since the phase $\theta$ is included in the range $\{\pi \leqq \theta < 2\pi\}$, selector 205 selects the input signal supplied by negative or inverting amplifier 204. By this process, memory 202 is not required to store the data of a full-cycle of the sine function. Therefore, it is possible to employ a memory having a small capacity for memory 202 in the phase modulator.

In the phase modulator of Figure 2, the phase resolution $\Delta\theta$ is expressed by the following formula:

$$\Delta\theta = 2\pi/A$$

where A is the number of read address data. However, in the conventional phase modulator of Figure 4, the phase resolution $\Delta\theta$ is limited to some specified values because the number A must be selected among numbers expressed by the Nth power of 2. In other words, if setting the number A as a free value in order to get a desired phase resolution, it is required to employ a memory with such a large capacity as to store a full-cycle of sine wave data.

In accordance with this invention, an apparatus is provided for modulating an input signal and producing an output signal having a desired resolution. The apparatus includes an integrator which integrates the input signal and produces the remainder with where the integrated data is divided by a predetermined value. For instance, the integrator initializes the integrated data to initial or default value data when the integrated data becomes equal to the predetermined value. The apparatus also includes a phase modulator which receives the remainder as phase data corresponding to phase $\theta$ in the range $\{0 \leqq \theta < 2\pi\}$ and produces cyclic function data in accordance with the phase data. In an appropriate example of the phase modulator, a memory is employed for storing the data which are half-cycle or quarter-cycle data of the cyclic function, and a device is also employed for supplying the memory with read address data corresponding to phase $\theta$ in half or quarter of the range $\{0 \leqq \theta < 2\pi\}$.

The present invention seeks to provide a digital frequency modulator by which a desired frequency resolution is exactly obtained.

The present invention also seeks to provide a digital frequency modulator including an integrator which can set a counter regression value at a desired value and a phase modulator which can obtain a desired phase resolution corresponding to the counter regression value of the integrator even if a memory having a small capacity is used.

For a better understanding of the present invention, and to show how it may be brought into effect, reference will now be made, by way of example, to the accompanying drawings, in which:

Figure 1 is a schematic block diagram illustrating a known digital frequency modulator comprising an integrator and a phase modulator.

Figure 2 is a schematic block diagram illustrating the memory portion of a known phase modulator.

Figure 3 is a block diagram illustrating a known integrator

Figure 4 is a block diagram illustrating a known phase modulator.

Figure 5 is a wave form chart showing a sine function for the phase modulator of Figure 4.

Figure 6 is a block diagram illustrating an integrator employed for a digital frequency modulator in accordance with an embodiment of the present invention.

Figure 7 is a graph showing a relation between clock count and output data for the integrator of Figure 6.

Figure 8 is a block diagram illustrating a phase modulator employed for the digital frequency modulator according to a first embodiment of the present invention.

Figure 9 is a wave form chart showing a sine function for the phase modulator of Figure 8.

Figure 10 is a block diagram illustrating a phase modulator used for a second embodiment of the present invention.

Figure 11 is a wave form chart showing a sine function for the phase modulator of Figure 10.

Representative embodiments of the present invention will now be explained with reference to the accompanying drawings.

In an embodiment of the present invention discussed below, a digital frequency modulator comprising an integrator and a phase modulator as shown in Figure 1 is designed to be applied to a VCR by way of one example for utilization of the present invention. Therefore, the frequency resolution of the digital frequency modulator is required to satisfy a relation expressed by the formula (2) described above. In other words, it is necessary to make an integral multiple of the frequency resolution $\Delta f$ equal to $f_H/2$ exactly where $f_H$ is the horizontal synchronizing frequency for a typical video signal. For this reason, this embodiment provides an integrator capable to be set, in accordance with the formula (3), as the following value:

clock frequency $f_{ck} = 1820f_H$;
counter regression value L1 = 10920; and n = 3

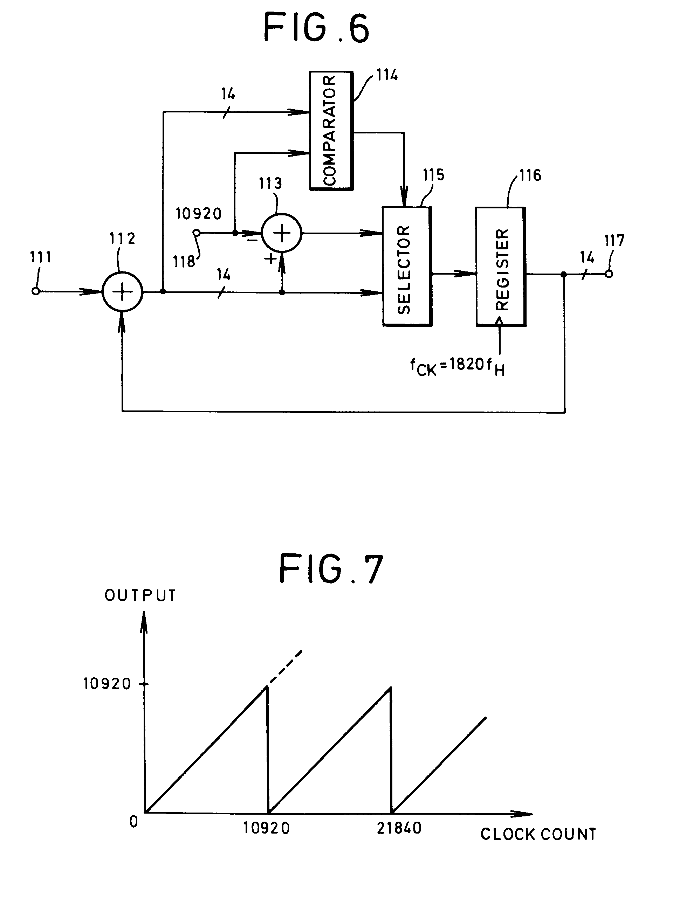

Figure 6 is a block diagram illustrating an integrator used for this embodiment but incorporating the principle of the present invention. The integrator operates in the following manner. An input signal having a certain voltage level is supplied to adder 112 via input terminal 111. Adder 112 adds the input signal and output data from register 116, and supplies the added data having a bit-width of 14 bits to comparator 114, subtractor 113 and one of the two input terminals of selector 115. Regression data which is set, for the purpose of the video example, equal to "10920" is supplied to input terminal 118, and is supplied to comparator 114 and subtractor 113. Subtractor 113 subtracts the regression data from the added data and supplies the difference data to the other input terminal of selector 115. Comparator 114 compares the added data from adder 112 with the regression data. As a result, when the added data is less than the regression data, selector 114 is controlled by a control signal supplied by comparator 114 so that the added data from adder 112 is supplied to register 116 : when the added data is equal to or greater than the regression data, selector 114 is controlled by the control signal so that the difference data from subtractor 113 is supplied to register 116. Register 116 is driven by a clock signal having a frequency $f_{ck}$ (= 1820 $f_H$) in the video example and supplies output data to adder 112 and output terminal 117.

Figure 7 is a graph showing a relation between clock count and output data in accordance with the integrator of Figure 6 when an input signal of the integrator is continuously set equal to "1". As is apparent from Figure 7, the output data of the integrator has any of the numerical values less than "10920" and, namely, indicates the remainder where the regression data (10920) is subtracted from or is divided into the data generated by integrating the input signal.

In the above integrator of this embodiment of the present invention, counter regression value L1 is set equal to "10920" in order to get the value of exactly $f_H/2$ by multiplying the frequency resolution $\Delta f$ by n (=3). However, counter regression value L1 may be set to any desired value by changing the regression data supplied to input terminal 118 in Figure 6. In other words, the frequency resolution $\Delta f$ can be freely set to any desired value. In addition, the frequency resolution $\Delta f$ corresponds to the phase resolution $\Delta \theta$ in a phase modulator which will be discussed below.

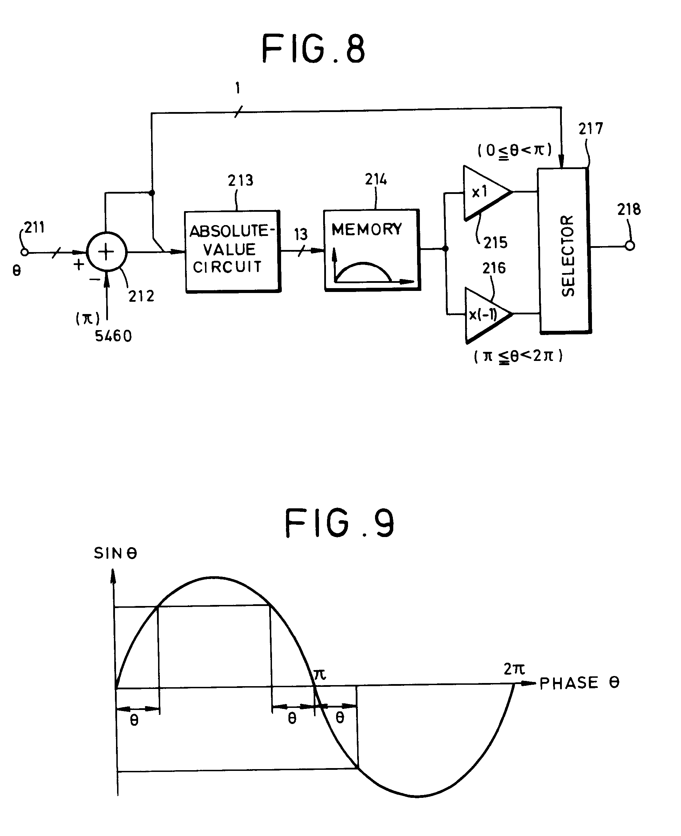

Figure 8 is a block diagram illustrating a phase modulator employed for the digital frequency modulator of this embodiment of the present invention. In this phase modulator, digital data which is output data of the integrator described above in the form of phase data $\theta$ is supplied to input terminal 211. The phase data can have any of 10920 numerical values from "0" to "10919" corresponding to phase $\theta$ in the range $\{0 \leq \theta < 2\pi\}$, and has a bit-width of 14 bits. In this case,

the phase resolution $\Delta \theta$ becomes the value $2\pi/10920$.

The phase modulator of Figure 8 operates in the following manner. The phase data is supplied to one of the input terminals of subtractor 212, while reference data equal to the value "5460" (= 10920/2) is supplied to the other input terminal of subtractor 212. Note that the reference data is equivalent to the value expressing phase $\pi$. Subtractor 212, therefore, supplies the difference data corresponding to the value $\theta$-$\pi$ to absolute-value circuit 213. In addition, the borrow data of subtractor 212 indicates whether or not the phase data is greater than the reference data, and is supplied to the control terminal of selector 217. The absolute-value data corresponding to value $|\theta-\pi|$ is produced by absolute-value circuit 213 and is supplied to memory 214 as read address data which has a bit-width of 13 bits. Memory 214 stores half-cycle data of the sine function corresponding to the range $\{0 \leq \theta < \pi\}$.

The output data read out from memory 214 is supplied to positive $\{x1\}$ amplifier 215 and negative or inverting $\{x(-1)\}$ amplifier 216 which inverts the data. Both output signals of these amplifiers are supplied to respective input terminals of selector 217. Thus, when the borrow data from subtractor 212 indicates a negative, since phase $\theta$ of the phase data is included in the range $\{0 \leq \theta < \pi\}$, selector 217 selects the output signal of positive amplifier 215 to supply to output terminal 218. On the other hand when the borrow data indicates a positive, since phase $\theta$ of the phase data is included in the range $\{\pi \leq \theta < 2\pi\}$, selector 217 selects the output signal of negative amplifier 216 to supply to output terminal 218.

By this process, even if memory 214 stores only the data corresponding to phase $\theta$ in the range $\{0 \leq \theta < \pi\}$, full-cycle data of the sine function corresponding to phase $\theta$ in the range $\{0 \leq \theta < 2\pi\}$ is obtained as the output signal of the phase modulator. In the phase modulator used for this embodiment, as is apparent from Figure 9 which is a wave form chart showing the sine function for the phase modulator of Figure 8, the characteristic of the sine function which is point symmetric to phase $\pi$ is used. This characteristic is expressed as the following:

$$\sin \theta = - \sin(\pi + \theta) = \sin (\pi - \theta)$$

In accordance with this embodiment, the frequency modulator employs an integrator in which a frequency resolution can be freely set to any desired value. The frequency modulator also employs a phase modulator which can accept the input data having any phase resolution corresponding to the frequency resolution set by the above integrator without increasing a memory's capacity.

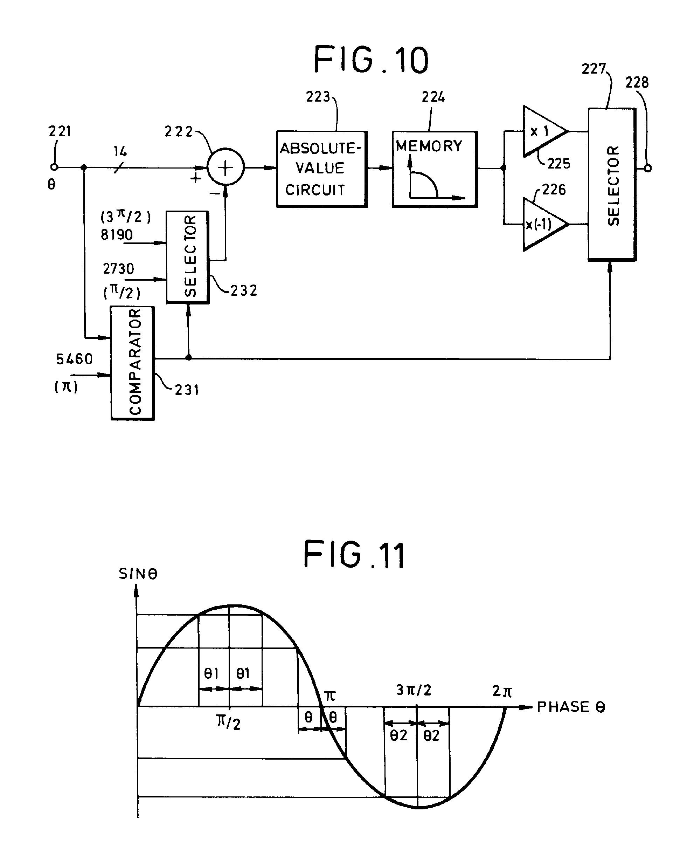

Figure 10 is a block diagram illustrating a phase modulator used for another embodiment of this invention. This embodiment differs from the above embodiment with respect to the phase modulator of Figure 10 which maybe used in place of the phase modulator of Figure 8. In this embodiment, the phase modulator is designed so that quarter-cycle data of the sine function as enough may be stored in a memory. In other words, as is apparent from Figure 11, the phase modulation takes into account the characteristics of the sine function as the following:

$$\sin (\pi + \theta) = - \sin(\pi - \theta);$$
$$\sin (\pi/2 + \theta1) = \sin (\pi/2 - \theta1); \text{ and}$$
$$\sin (3\pi/2 + \theta2) = \sin (3\pi/2 - \theta2)$$

In the phase modulator of Figure 10, the phase data supplied to input terminal 221 can have any of 10920 numerical values from "0" to 10919". The phase data is supplied to subtractor 222 and comparator 231. In addition, first reference data having the value "5460" (10920/2) equivalent to phase $\pi$ is supplied to comparator 231. Thus, comparator 231 compares the phase data with the first reference data, and supplies a control signal indicating the comparison result to each of control terminals of selectors 227 and 232. Selector 232 is supplied with second reference data having the value "2730" (10920/4) equivalent to phase $\pi/2$ and third reference data having the value "8190" equivalent to phase $3\pi/2$. In accordance with the control signal from comparator 231, when the phase data is less than the first reference data, namely in the case where phase $\theta$ of the phase data is included in the range $\{0 \leqq \theta < \pi\}$, selector 232 selects the second reference data (2930) for supplying it to subtractor 222 and when the phase data is equal to or greater than the first reference data, namely in the case where phase $\theta$ is included in the range $\{\pi \leqq \theta < 2\pi\}$, selector 232 selects the third reference data (8190) for supplying it to subtractor 222.

Subtractor 222 subtracts the second or third reference data from the phase data. Therefore, in the case where phase $\theta$ of the phase data is included in the range $\{0 \leqq \theta < \pi\}$, subtractor 222 executes the subtraction equivalent to $\theta-\pi/2$. However, in the case where phase $\theta$ is included in the range $\{\pi \leqq \theta < 2\pi\}$, subtractor 222 executes the subtraction equivalent to $\theta-3\pi/2$. The difference data produced by subtractor 222 is supplied to absolute-value circuit 223 for providing the absolute-value data equivalent to $|\theta-\pi/2|$ or $|\theta- 3\pi/2|$, which is used as read address data for memory 224. Memory 224 stores quarter-cycle sine wave data which correspond to the range $\{\pi/2 \leqq \theta < \pi\}$. The output data read out from memory 224 is supplied to both positive amplifier 225 and negative amplifier 226. Both output signals of these amplifiers are supplied to respective input terminals of selector 227. Thus, when the control signal indicates that phase $\theta$ of the phase data is included in the range $\{0 \leqq \theta < \pi\}$, selector 227 selects the output signal of positive amplifier 225 for supplying it to output terminal 228 and when the control signal indicates that phase $\theta$ is included in the range $\{\pi \leqq \theta < 2\pi\}$, selector 227 selects the output signal of negative amplifier 226 for supplying it to output terminal 228.

In accordance with this embodiment, the phase modulator may store only quarter-cycle sine wave data in order to have the output data corresponding to the entire phase of a full-cycle. Therefore, the phase modulator can employ a memory which has a small capacity and a large capacity memory is avoided.

In the above embodiments, the phase modulators employ memories in which the data of the sine function are stored. However, the phase modulators may make each memory store the data of other cyclic functions as well. Such cyclic functions should preferably have the symmetrical properties exhibited by the sine wave function discussed herein. In addition, the integrator and the phase modulators in the embodiments are constituted by hardware. However, it may be understood by those in the art that software of a microcomputer and so on can take the place of some hardware portions of the circuits described above.

As described above, the present invention provides a digital frequency modulator by which a desired frequency resolution is exactly obtained. In order to provide an improved digital frequency modulator, the present invention also provides an integrator in which a counter regression value can be freely set to any desired value, and a phase modulator in which a desired phase resolution can be obtained even if a memory having a small capacity is used.

**Claims**

1. Apparatus for modulating an input signal with an integration operation and a phase modulating operation, said apparatus comprising:

    input means (111) positioned at an initial stage in said integration operation for receiving said input signal;

    register means (116) positioned at a later stage in said integration operation for temporarily holding and supplying integrated data;

    addition means (112) coupled to said input means (111) and said register means (116) for receiving and adding said input signal and said integrated data, and for providing added data;

    phase modulating means (112), (218) positioned in said phase modulating operation and coupled to said register means (116) for receiving said integrated data and providing phase modulated data in accordance with said integrated data; and

    characterised in that said apparatus further comprises:

    remainder calculating means (113), (114), (115), (118) coupled to said addition means (112) and said register means (116) for receiving said added data and calculating the remainder where

said added data is compared with a predetermined value, and for supplying said register means with said remainder as said integrated data.

2. Apparatus as claimed in claim 1, wherein said remainder calculating means includes:

comparing means (114) for comparing said added data with said predetermined value and providing a control signal indicating whether or not said added data is less than said predetermined value; and

selecting means (115) coupled to said comparing means (114) for receiving said control signal, selecting said added data as said remainder when said control signal indicates that said added data is less than said predetermined value and selecting an initial data of said integration operation as said remainder when said added data is not less than said predetermined value.

3. Apparatus as claimed in claim 1 or 2, wherein said phase modulating means includes:

memory means (214) for storing cyclic function data which is provided as said phase modulated data and receiving read address data to read out said cyclic function data; and

address means (212), (213) for producing said address data which indicates a phase of said cyclic function data in accordance with said integrated data and supplying said address data to said memory means (214).

4. Apparatus for modulating an input signal to product an output signal having a desired resolution, said apparatus comprising:

integration means (111), (112), (116) for receiving said input signal, integrating said input signal at the timing of a clock signal and providing integrated data;

modulating means (211), (218) coupled to said integration means for receiving said integrated data and providing said output signal in accordance with said integrated data;

characterised in that said apparatus further comprises:

initialising means (113), (114), (115), (118) coupled to said integration means for receiving said integrated data and comparing said integrated data with a predetermined reference value, and said initialising means resetting said integrated data to an initial value when said integrated data becomes greater than said reference value;

wherein said desired resolution is provided by selecting the frequency of said clock signal and said reference value.

5. Apparatus as claimed in claim 4, wherein said initialising means calculates the remainder where said integrated data is compared with said reference value, and supplying said remainder as said integrated data to said integration means.

6. Apparatus for modulating an input signal, said apparatus comprising:

integration means (111), (118) for receiving said input signal and integrating said input signal to provide integrated data, said integrated data being limited to be less than a predetermined value;

characterised in that said apparatus further comprises:

address means (211), (212), (213) coupled to said integration means for receiving said integrated data and comparing said integrated data with reference data having half the value of said predetermined value, said address means providing a control signal which indicates whether or not said integrated data is less than said reference data, and providing read address data having an absolute-value of the difference between said integrated data and said reference data;

memory means (214) coupled to said address means (211), (212), (213) for receiving said address data and storing half-cycle data of a cyclic function to read out said half-cycle data in accordance with said read address data; and

output means (215), (216), (217) coupled to said address means (211), (212), (213) and said memory means (214) for receiving said control signal and said half-cycle data and inverting said half-cycle data, said output means selectively providing one of said half-cycle data and the inverted half-cycle data in accordance with said control signal.

7. Apparatus for modulating an input signal, said apparatus comprising:

integration means (111), (118) for receiving said input signal and integrating said input signal to provide integrated data, said integrated data corresponding to phase $\theta$ in the range $\{0 \leq \theta < 2\pi\}$ where $\pi$ is the ratio of the circumference of a circle to its diameter;

characterised in that said apparatus further comprises:

comparing means (231) coupled to said integration means for receiving said integrated data and comparing said integrated data with first reference data corresponding to phase $\pi$, said comparing means providing a control signal which indicates whether said phase $\theta$ of said integrated data is included in the range $\{0 \leq \theta < \pi\}$ or $(\pi \leq \theta < 2\pi\}$;

address means (222), (223), (232) coupled to said integration means and comparing means (231) for receiving said integrated data and said control signal and providing address data, said address data having an absolute-value of the difference between said integrated data and second reference data corresponding to phase $\pi/2$ when said control signal indicates that said phase $\theta$ is included in the range $\{0 \leqq \theta < \pi\}$, and having an absolute-value of the difference between said integrated data and third reference data corresponding to phase $3\pi/2$ when said control signal indicates that said phase $\theta$ is included in the range $\{\pi \leqq \theta < 2\pi\}$;

memory means (224) coupled to said address means (222), (223), (232) for receiving said address data and storing quarter-cycle data of a cyclic function to read out said quarter-cycle data in accordance with said address data; and

output means (225), (226), (227) coupled to said comparing means (231) and said memory means (224) for receiving said control signal and said quarter-cycle data and inverting said quarter-cycle data, said output means selectively providing one of said quarter-cycle data and the inverted quarter-cycle data in accordance with said control signal.

8.  Method for modulating an input signal with an integration operation and a phase modulating operation, said method comprising the steps of:

receiving said input signal at an initial stage in said integration operation;

adding said input signal and integrated data which is supplied by a register device operated at a later stage in said integration operation, and providing added data;

calculating the remainder where said added data is compared with a predetermined value and supplying said register device with said remainder as said integrated data;

temporarily holding and supplying said integrated data; and

receiving said integrated data in said phase modulating operation and providing phase modulated data in accordance with said integrated data.

9.  Method as claimed in claim 8, wherein said remainder is calculated by the steps of:

comparing said added data with said predetermined value and providing a control signal indicating whether or not said added data is less than said predetermined value; and

receiving said control signal, selecting said added data as said remainder when said control signal indicates that said added data is less than said predetermined value and selecting an initial data of said integration operation as said remainder when said added data is not less than said predetermined value.

10. Method as claimed in claim 8 or 9, wherein said phase modulated data is provided by the steps of:

producing address data which indicates a phase of cyclic function data in accordance with said integrated data and supplying said address data to a memory which stores said cyclic function data; and

reading out said cyclic function data from said memory in accordance with said address data and providing said cyclic function data as said phase modulated data.

11. Method for modulating an input signal to produce an output signal having a desired resolution, said method comprising the steps of:

receiving said input signal;

integrating said input signal at the timing of a clock signal and providing integrated data;

comparing said integrated data with a predetermined reference value, and resetting said integrated data to an initial value when said integrated data becomes greater than said reference value; and

receiving said integrated data and providing said output signal in accordance with said integrated data;

wherein said desired resolution is provided by selecting the frequency of said clock signal and said reference value.

12. Method as claimed in claim 11, wherein said integrated data is compared and is reset by the step of:

calculating the remainder where said integrated data is compared with said reference value, and supplying said remainder as said integrated data.

13. Method for modulating an input signal, said method comprising the steps of:

receiving said input signal and integrating said input signal to provide integrated data, said integrated data being limited to be less than a predetermined value;

comparing said integrated data with reference data having half the value of said predetermined value and providing a control signal which indicates whether or not integrated data is less than said reference data;

providing read address data having an absolute-value of the difference between said integrated data and said reference data;

reading out half-cycle data of a cyclic function from a memory in accordance with said read address data;

inverting said half-cycle data and providing inverted half-cycle data; and

selectively providing one of said half-cycle data and said inverted half-cycle data in accordance with said control signal.

14. Method for modulating an input signal, said method comprising the steps of:

receiving said input signal and integrating said input signal to provide integrated data, said integrated data corresponding to phase θ in the range {0 ≦ θ < 2π} where π is the ratio of the circumference of a circle to its diameter;

comparing said integrated data with first reference data corresponding to phase π and providing a control signal which indicates whether said phase θ of said integrated data is included in the range {0 ≦ θ < π} or {π ≦ θ < 2π};

providing address data, said address data having an absolute-value of the difference between said integrated data and second reference data corresponding to phase π/2 when said control signal indicates that said phase θ is included in the range {0 ≦ θ < π}, and having an absolute-value of the difference between said integrated data and third reference data corresponding to phase 3π/2 when said control signal indicates that said phase θ included in the range {π ≦ θ < 2π};

reading out quarter-cycle data of a cyclic function from a memory in accordance with said address data;

inverting said quarter-cycle data and providing inverted quarter-cycle data; and

selectively providing one of said quarter-cycle data and said inverted quarter-cycle data in accordance with said control signal.

15. An integrator for integrating an input signal comprising:

input means (111) for receiving said input signal;

register means (116) for temporarily holding and supplying said integrated data at the timing of a clock signal;

addition means (113) coupled to said input means (111) and said register means (116) for receiving and adding said input signal and said integrated data, and for supplying added data as said integrated data to said register means;

characterised in that said integrator further comprises:

remainder calculating means (113), (114), (115), (118) coupled to said addition means (112) and said register means (116) for receiving said added data and calculating the remainder by comparison to a predetermined value, and for supplying said register means (116) with said remainder as said integrated data.

16. An integrator as claimed in claim 15, wherein said remainder calculating means includes:

comparing means (114) for comparing said added data with said predetermined value and providing a control signal indicating whether or not said added data is less than said predetermined value; and

selecting means (115) coupled to said comparing means for receiving said control signal, selecting said added data as said remainder when said control signal indicates that said added data is less than said predetermined value and selecting an initial data as said remainder when said added data is not less than said predetermined value.

17. An apparatus as claimed in claim 4, or a method as claimed in claim 11, or an integrator as claimed in claim 15 or claim 16, wherein the frequency ($f_{ck}$) of said clock signal and said predetermined value (L1) are selected to satisfy the following formula:

$$fH/2 = n.f_{ck}/L1$$

where fH is the horizontal synchronising frequency of a television signal, and n is an integer.

18. A phase modulator for modulating input data being limited to be less than a predetermined value, characterised in that said phase modulator comprises:

address means (211), (212), (213) for receiving said input data and comparing said input data with reference data having half the value of said predetermined value, said address means providing a control signal which indicates whether or not said input data is less than said reference data, and providing read address data having an absolute-value of the difference between said input data and said reference data;

memory means (214) coupled to said address means (211), (212), (213) for receiving said address data and storing half-cycle data of a cyclic function to read out said half-cycle data in accordance with said read address data; and

output means (215), (216), (217) coupled to said address means (211), (212), (213) and said memory means for receiving said control signal and said half-cycle data and inverting said half-cycle data, said output means selectively providing one of said half-cycle data and the inverted half-cycle data in accordance with said control signal.

19. Apparatus as claimed in claim 6, or a method as claimed in claim 13 or a phase modulator as claimed in claim 18, wherein said input data and said predetermined value correspond to phase θ

in the range $\{0 \leqq \theta < 2\pi\}$ and phase $2\pi$, respectively, where $\pi$ is the ratio of the circumference of a circle to its diameter.

20. An apparatus or a method as claimed in claim 19, wherein said cyclic function is a sine wave function.

21. A phase modulator for modulating input data corresponding to phase $\theta$ in the range $\{0 \leqq \theta < 2\pi\}$ where $\pi$ is the ratio of the circumference of a circle to its diameter, characterised in that said phase modulator comprises:

comparing means (231) for receiving said input data and comparing said input data with first reference data corresponding to phase $\pi$, said comparing means providing a control signal which indicates whether said phase $\theta$ of said input data is included in the rage $\{0 \leqq \theta < \pi\}$ or $\{\pi \leqq \theta < 2\pi\}$;

address means (222), (223), (232) for receiving said input data and said control signal and providing address data, said address data having an absolute-value of the difference between said input data and second reference data corresponding to phase $\pi/2$ when said control signal indicates that said phase $\theta$ is included in the range $\{0 \leqq \theta < \pi\}$, and having an absolute-value of the difference between said input data and third reference data corresponding to phase $3\pi/2$ when said control signal indicates than said phase $\theta$ is included in the range $\{\pi \leqq \theta < 2\pi\}$;

memory means (224) coupled to said address means (222), (223), 232) for receiving said address data and storing quarter-cycle data of a cyclic function to read out said quarter-cycle data in accordance with said address data; and

output means (225), (226), (227) coupled to said comparing means (231) and said memory means (224) for receiving said control signal and said quarter-cycle data and inverting said quarter-cycle data, said output means selectively providing one of said quarter-cycle data and the inverted quarter-cycle data in accordance with said control signal.

22. Modulation apparatus comprising an integrator for converting an input signal to phase data and a phase modulator for converting the phase data to frequency data, the integrator having an addition circuit and a register with the addition circuit arranged to add the input signal to the register output and with its output coupled to the register input, characterised in that the output of the addition circuit is fed to a comparison arrangement to be compared with a predetermined value and the arrangement further includes means for feeding the output of the addition circuit to said register input when its value is lower than said predetermined value and to feed the difference between said predetermined value and the addition circuit output to the register input if this output exceeds the predetermined value.

# FIG.1 (Prior art)

V →| INTEGRATOR (100) |→ θ →| PHASE MODULATOR (200) |→ f

# FIG.2 (Prior art)

ADDRESS (θ) →| MEMORY (250) |→ DATA (f)

250   200

# FIG.3 (Prior art)

101 →| + (102) |→ 13 →| REGISTER (103) |→ 104

$f_{CK} = 1365 f_H$

100

# FIG. 4 (Prior art)

1(MSB)

203

202

(0 ≦ θ < π)

13

12

MEMORY

× 1

SELECTOR

206

201

200

× (-1)

(π ≦ 0 < 2π)

204

# FIG. 5 (Prior art)

SIN θ

π

2π

PHASE θ

θ

π

θ

# FIG.6

# FIG.7

# FIG.8

# FIG.9

# FIG.10

# FIG.11